# EUROPEAN PATENT SPECIFICATION

(11) **EP 3 663 781 B1**
(45) Date of publication and mention of the grant of the patent: **13.07.2022**
(21) Application number: 18210637.7
(22) Date of filing: 06.12.2018
(51) Int. Cl.: G01R 31/392, H02J 7/00

(54) **CHARGE MONITOR, CHARGER AND CHARGE MONITORING METHOD BASED ON RECHARGE FREQUENCY**
LADEMONITOR, LADEGERÄT UND LADEÜBERWACHUNGSVERFAHREN AUF BASIS DER LADEFREQUENZ
MONITEUR DE CHARGE, CHARGEUR ET PROCÉDÉ DE SURVEILLANCE DE CHARGE BASÉ SUR LA FRÉQUENCE DE RECHARGE

(43) Date of publication of application: 10.06.2020
(73) Proprietor: Tridonic GmbH & Co. KG, 6851 Dornbirn (AT)
(72) Inventor: Wilson, Ian, Sunderland SR33RH (GB)
(74) Representative: Rupp, Christian

(56) References cited:
- EP-A2- 2 151 694
- WO-A1-2017/170205
- US-A1- 2018 262 027

## Description

The invention relates to determining a status of a rechargeable battery pack, especially a lithium-ion based battery pack.

Recently Lithium-ion Phosphate cells have been introduced in emergency lighting devices. It is normal with Lithium battery packs to connect cells in parallel to support self-balancing of the cells used in the pack without the need for complex balancing circuits. However, in the case of one of the cells becoming damaged or leaking electrolyte, it is not possible inside current emergency chargers to detect this condition, since the cells are connected in parallel. The electrolyte leakage condition can in itself lead to a short circuit of the battery pack through conductive deposits between anode and cathode or by damage to circuits, which are connected to the cells. This problem would be accelerated if charging continues, since charging generates pressure inside the cells of the battery pack.

Lithium cells are usually charged using a constant current followed by a constant voltage, and in the case of Lithium Phosphate cells the charger is switched off once the battery has reached typically 3.6V. Charging would resume when the battery voltage decays to 3.4V. This normally takes many hours due to the low self-discharge rate of the Lithium cells. Until now charging is started and stopped according these voltage levels and independent of further factors.

For example the document EP 2 837 258 A1 shows a battery monitoring based upon an impedance level of the battery. This approach though requires additional measurements, which increase the complexity of the hardware.

For example the document US 2018/262027 A1 discloses a charge monitor according to the preamble of independent claim 1 for monitoring a charging process of a battery pack by a charger.

Accordingly, the object of the invention is to provide a charge monitor and an according method which allow for an accurate monitoring of the battery status without requiring complex hardware.

The object is solved by the features of claim 1 for the device and by the features of claim 12 for the method. Further it is solved by the features of claim 13 for the associated computer program. The dependent claims contain further developments.

A proposal is described in the following, whereby it is possible to detect a damaged or leaking battery and to prevent charging which could result in Lithium plating and catastrophic failure of the battery pack.

An inventive charge monitor for monitoring a charging process of a battery pack by a charger, comprises a recharge frequency determiner, which is adapted to determine a recharge frequency of the battery pack, and a battery pack status determiner, adapted to determinate status of the battery pack based on the recharge frequency. It is thereby possible to determine the status of the battery pack without requiring complex additional hardware.

Advantageously, the recharge frequency determiner is adapted to determine charge times of the battery pack and/or determine discharge times of the battery pack during a preset time period. Moreover, the recharge frequency determiner is then adapted to determine the recharge frequency of the battery pack from the determined charge times of the battery pack and/or discharge times of the battery pack within the preset time period. This allows for an especially simple and accurate determining of the status.

Further advantageously, the recharge frequency determiner is adapted to determine a charge time as a time from a beginning of a charging cycle until an end of the charging cycle. Additionally, or alternatively, the recharge frequency determiner is adapted to determinate discharge time as a time from an end of a charging cycle until a beginning of a further charging cycle. This allows for an especially simple implementation.

Advantageously, the recharge frequency determiner is adapted to monitor a voltage of the battery pack connected to the charger, determine a beginning of a charging cycle, if the voltage falls below a first voltage threshold and subsequently rises above the first voltage threshold, and determine an end of a charging cycle, if the voltage surpasses a second charging cycle. This allows for a very simple determining of the charging cycle.

The battery pack status determiner is adapted to determine the status of the battery pack as operational, if the recharge frequency is below a first threshold, and as damaged, if the recharge frequency is above the first threshold. This allows for a very simple determining of the status of the battery pack.

Further advantageously, the battery pack status determiner is adapted to, within a commissioning time beginning at a beginning of a first charging of the battery pack by the charger, ending after a nominal voltage of the battery pack has been reached for a first time, increase the first threshold. Due to the necessary repetition of a charge cycle, during the commissioning period, by this measure, an accidental detection of a faulty battery during commissioning time can be prevented.

Advantageously, the battery pack status determiner is further adapted to read out of a battery statistics storage of the battery pack, an age and/or a number of previous charging cycles of the battery pack. If the age of the battery pack is above a third threshold, and/or a number of previous charging cycles of the battery pack is above a forth threshold, the battery pack status determiner is adapted to increase the first threshold. Since older battery packs or battery packs, which have already undergone a significant number of charging cycles usually have to be charged more often, this measure allows a prevention of an involuntary detection of a faulty battery for this case.

The charge monitor comprises a temperature sensor, adapted to measure a temperature of the battery pack. If the temperature surpasses a fifth threshold, the battery pack status determiner is adapted to increase the first threshold. Since warm batteries usually have an increased discharge rate, an increased recharging frequency is necessary. By this measure, a involuntary detection of a faulty battery in case of a warm battery is prevented.

An inventive charging device comprises a charger, adapted to charge a battery pack and a previously described charged monitor. This allows for a safe and efficient charging of the battery pack.

Advantageously, the charger is adapted to monitor a voltage of the battery pack connected to the charger, determining the beginning of a charging cycle, if the voltage falls below a first voltage threshold and subsequently rises above the first voltage threshold, and determining an end of a charging cycle if the voltage surpasses a second charging cycle. This allows for an especially efficient charging.

An inventive battery system comprises a previously described charging device and a rechargeable battery. This allows for a very efficient provision of energy.

An inventive emergency lighting driver comprises a previously described charging device and a rechargeable battery pack.

An inventive emergency lighting device comprises a previously described emergency lighting driver and a light source which is designed to be powered from the battery pack in case of an emergency lighting situations.

An inventive method for monitoring a charging process of a battery pack comprises determining a recharge frequency of the battery pack and determining a status of the battery pack based upon the recharge frequency. It is thereby possible to determine the status of the battery pack without requiring complex additional hardware.

An inventive computer program comprises a program code for performing the previously described method, when the computer program runs on a computer. It is thereby possible to determine the status of the battery pack without requiring complex additional hardware.

An exemplary embodiment of the invention is now further explained with respect to the drawings, in which
- Fig. 1: shows a typical charging cycle of a lithiumbased rechargeable battery pack;
- Fig. 2: shows a first embodiment of the inventive charge monitor in a block diagram;
- Fig. 3: shows a detail of a second embodiment of the inventive charge monitor;
- Fig. 4: shows an exemplary charging voltage and current in a third embodiment of the inventive charge monitor, and
- Fig. 5: shows an embodiment of the inventive method in a flow diagram.

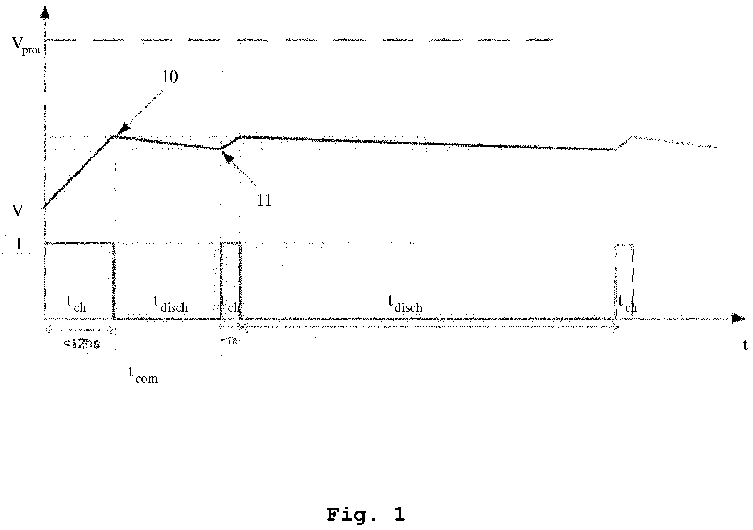

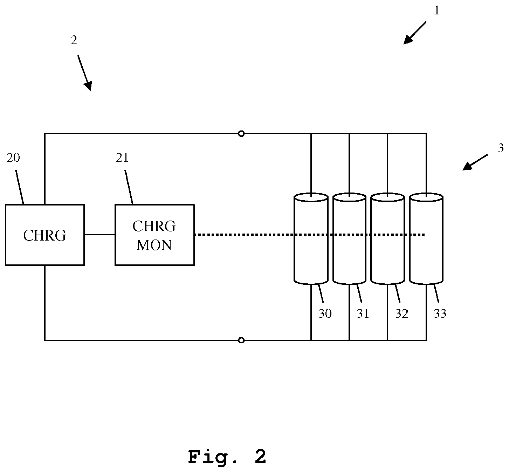

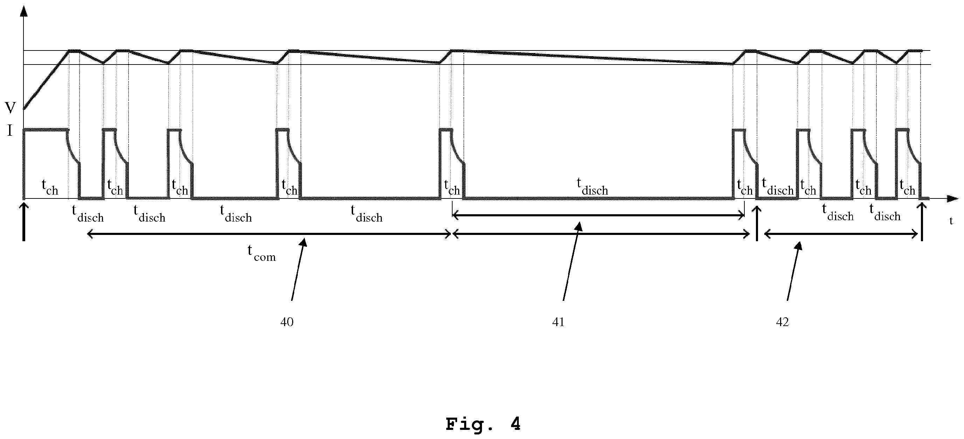

First, we demonstrate the general function of a charging process of lithium-based rechargeable battery packs along Fig. 1. In Fig. 2 - 3, different embodiments of the inventive charge monitor are shown. With regard to Fig. 4, further details of the inventive charge monitor are described along an exemplary charging voltage and current.

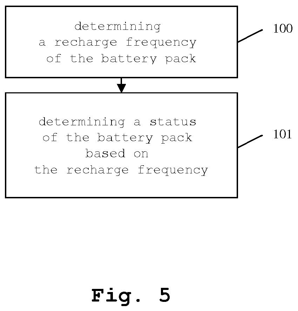

Finally, in respect to Fig. 5, an embodiment of the inventive method is described in detail.

In Fig. 1, a typical charging of a lithium-based rechargeable battery pack is shown. In the diagram, on the x-axis, time is displayed, while on the y-axis, the voltage V of the battery pack, and the charging current I of the battery pack are displayed.

During an initial charging period t_{ch}, which can easily surpass 12 hours, the rechargeable battery pack is brought up to nominal voltage. As soon as this nominal voltage of e.g. 3.6 V has been reached at a time 10, the charger disengages, and the battery pack slowly discharges. This happens until the voltage has dropped to e.g. 3.4 V at the time instance 11. The discharging time is referred to as t_{disch}. As soon as this lower threshold voltage is passed, a further charging cycle is initiated. The now ensuing charging time is significantly shorter, since the voltage only has to be brought up from 3.4 V to 3.6 V. The initial charging time and discharging time are referred to as commissioning time t_{com}. After this, a regular operation of the battery pack ensues. The interval of necessary charging is rather long, the resulting recharge frequency is very low.

It should be noted that during the commissioning time, it might not be possible to reach the nominal voltage of the battery pack in an initial charging cycle. In this case, a pulsed charging operation during the commissioning phase is performed. This, though, is not subject of the present application.

When the rechargeable battery pack experiences leakage, especially electrolyte leakage, the discharge rate of the battery pack significantly increases, which significantly decreases the discharge time t_{disch}. This leads to a significant increase in necessary recharging frequency. The present invention relies upon determining this recharging frequency in order to determine the status of the rechargeable battery pack.

Additionally, in Fig. 1, a battery pack protection voltage V_{PROT} is shown. If the voltage surpasses this protection voltage V_{PROT}, the battery pack is disconnected.

In Fig. 2, an embodiment of the inventive charge monitor 21, as part of a charging device 2, as part of an inventive battery system 1, is shown. The battery system 1 comprises a charging device 2, which again comprises a charger 20 and a charge monitor 21. The battery system 1 moreover comprises a rechargeable battery pack 3, which comprises a number of cells 30-33. In this example, the cells are connected in parallel, which allows for a self-balancing of the cells 30-33, but makes a monitoring of the individual cells 30-33 impossible.

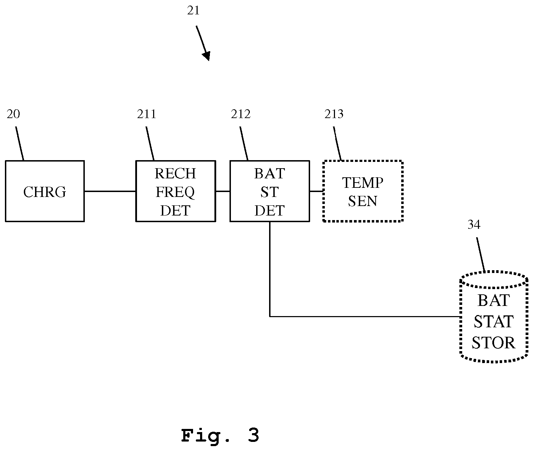

The terminals of the battery pack 3 are connected to the charger 20. The charger 20 is moreover connected to the charge monitor 21. The charge monitor 21 may optionally have a sensor connection to the battery pack 3. This is explained in further detail with regard to Fig. 3.

The battery system 1 with the charging device 2 may form a part of an emergency lighting driver. The emergency lighting driver may be a part of an emergency lighting device. The emergency lighting device may further comprise a light source which is designed to be powered from the battery pack 3 in case of an emergency lighting situation. Such emergency lighting situation may occur when the mains supply voltage of the emergency lighting driver fails. In such situation the emergency lighting driver may start operation of the light source and may thereby provide emergency lighting, e.g. for escape route illumination.

During operation, the charging device 2 charges the battery pack 3. Especially, the charger 20 charges the battery pack 3, while the charge monitor 21 monitors the charging by the charger 20. The detailed function of the different components is explained in detail along Fig. 3.

In Fig. 3, a detail of an embodiment of the inventive charge monitor of Fig. 2 is shown. The charge monitor 21 comprises a recharge frequency determiner 211 connected to a battery status determiner 212. The recharge frequency determiner 211 is connected to the charger 20 of Fig. 2.

The recharge frequency determiner 211 determines a recharge frequency of the battery pack 3 based upon the operations of the charger 20. Especially, the recharge frequency is determined 211 by the recharge frequency determiner based upon the charge times and/or discharge times of the battery pack. Especially, a charge time therein is determined as a time from a beginning of a charging cycle until an end of the charging cycle. A discharge time is determined as a time of an end of a charging cycle until a beginning of a further charging cycle.

Especially, the recharge frequency determiner 211 monitors a voltage of the battery pack 3 connected to the charger 20. This can be done through the connection to the charger 20, as displayed here, but also a direct connection of the recharge frequency determiner 211 to terminals of the battery pack 3 is possible. Based upon this voltage, the beginning of a charging cycle is determined by the recharge frequency determiner 211, if the voltage falls below a first threshold and subsequently rises above the first voltage threshold. An end of a charging cycle is determined by the recharge frequency determiner 211 if the voltage surpasses a second voltage threshold.

Based upon the recharge frequency determined by the recharge frequency determiner 211, the battery status determiner 212 determines the battery status. Especially, the battery status is determined as operational, if the recharge frequency is below a first threshold and is determined as damaged, if the recharge frequency is above the first threshold.

This first threshold though does not have to be a fixed pre-set value. This first threshold can be adapted based upon circumstances. Especially, the charge monitor can comprise a temperature sensor 213, which is connected to the battery status determiner 212, and monitors a temperature of the rechargeable battery pack 3. The battery status determiner 212 is then adapted to determine the status of the battery, additionally taking the temperature of the battery pack into account. Especially, the battery status determiner 212 can be adapted to increase the first threshold, in case the temperature of the battery pack surpasses a fifth threshold.

As a further circumstance, which can be taken into account by the battery status determiner 212, the commissioning of the battery pack can be regarded. In this case, the battery status determiner 212 increases the first threshold during a commissioning time of the battery pack. Such a commissioning time is a pre-set time interval after a first begin of charging of a battery pack, or the time until in nominal voltage of the battery pack is initially reached after begin of first charging of the battery pack.

A further circumstance, which can be taken into account is an age or a number of previous charging cycles of the battery pad. This information can be stored in a battery pack statistics storage 34, comprised by the battery pack 3. In this case, the battery status determiner 212 reads out the battery packs statistics storage 34 and increases the first threshold, in case the age of the battery pack is above a third threshold or in case of a number of previous charging cycles of the battery pack being above a forth threshold.

In Fig. 4, the life cycle of a battery pack is shown. On the x-axis again time is displayed, while on the y-axis, the battery pack voltage and current are displayed. During a commissioning time 40, also referred as T_{com}, a number of charging cycles of the battery pack are performed. The discharge times t_{disch} successively increase until a normal operation of the battery pack is reached. A single operation cycle 41 in nominal operation is shown here. During this time, a rather long discharge time t_{disch} is present. Finally, a fault detection period 42 is shown here. Suddenly, the discharge times t_{disch} are very short, leading to a high recharging frequency. This high recharging frequency is detected and considered as battery fault. It is important to note that a comparable recharging frequency during the commissioning time 40 is not necessarily regarded as a battery fault, since it is necessary during battery commissioning and does not indicate a faulty battery.

The invention is not limited to the examples and especially not to a specific recharging frequency or battery time. The invention discussed above can be applied to many different battery types, charger types and charging cycle times.

## Claims

1. Charge monitor (21) for monitoring a charging process of a battery pack (3) by a charger (20), comprising:
- a recharge frequency determiner (211), adapted to determine a recharge frequency of the battery pack (3), and
- a battery pack status determiner (212), adapted to determine a status of the battery pack (3) based on the recharge frequency as:
- operational, if the recharge frequency is below a first threshold, and
- damaged, if the recharge frequency is above the first threshold;
wherein the charge monitor (21) comprises a temperature sensor (213), adapted to measure a temperature of the battery pack (3),
**characterized in that** the battery pack status determiner (212) is adapted to increase the first threshold if the temperature surpasses a threshold.

2. Charge monitor (21) according to claim 1, wherein the recharge frequency determiner (211) is adapted to
- determine charge times (t_{ch}) of the battery pack (3) and/or determine discharge times (t_{disch}) of the battery pack (3) during a pre-set time period, and
- determine the recharge frequency of the battery pack (3) from the determined charge times (t_{ch}) of the battery pack (3) and/or discharge times (t_{disch}) of the battery pack (3) within the pre-set time period.

3. Charge monitor (21) according to claim 2, wherein the recharge frequency determiner (211) is adapted to
- determine a charge time (t_{ch}) as a time from a beginning of a charging cycle until an end of the charging cycle, and/or
- determine a discharge time (t_{disch}) as a time from an end of a charging cycle until a beginning of a further charging cycle.

4. Charge monitor (21) according to any of the claims 1 to 3,
wherein the recharge frequency determiner (211) is adapted to:
- monitor a voltage of the battery pack (3) connected to the charger (20),
- determine a beginning of a charging cycle, if the voltage falls below a first voltage threshold and subsequently rises above the first voltage threshold, and
- determine an end of a charging cycle, if the voltage surpasses a second voltage threshold.

5. Charge monitor (21) according to any of the claims 1 to 4,
wherein the battery pack status determiner (212) is adapted to, within a commissioning time (t_{com}) beginning at a beginning of a first charging of the battery pack (3) by the charger (20), ending after a nominal voltage of the battery pack (3) has been reached for a first time, increase the first threshold.

6. Charge monitor (21) according to any of the claims 1 to 5,
wherein the battery pack status determiner (212) is adapted to read out of a battery statistics storage (34) of the battery pack (3), an age and/or a number of previous charging cycles of the battery pack (3), and wherein, if the age of the battery pack (3) is above a third threshold, and/or a number of previous charging cycles of the battery pack (3) is above a fourth threshold, the battery pack status determiner (212) is adapted to increase the first threshold.

7. Charging device (2), comprising a charger (20), adapted to charge a battery pack (3), and a Charge monitor (21) according to any of the claims 1 to 6.

8. Charging device (2) according to claim 7,
wherein the charger (20) is adapted to
- monitor a voltage of the battery pack (3) connected to the charger (20),
- determine a beginning of a charging cycle, if the voltage falls below a first voltage threshold and subsequently rises above the first voltage threshold, and
- determine an end of a charging cycle, if the voltage surpasses a second charging cycle.

9. Battery system (1), comprising a charging device (2) according to claim 10 and a rechargeable battery pack (3).

10. Emergency lighting driver, comprising a charging device (2) according to claim 7 or 8 and a rechargeable battery pack (3).

11. Emergency lighting device, comprising an emergency lighting driver according to claim 10 and a light source which is designed to be powered from the battery pack (3) in case of an emergency lighting situations.

12. Method for monitoring a charging process of a battery pack (3), comprising:
- determining (100) a recharge frequency of the battery pack (3), and
- determining (101) a status of the battery pack (3) based on the recharge frequency as:
- operational, if the recharge frequency is below a first threshold, and
- damaged, if the recharge frequency is above the first threshold, and
- measuring a temperature of the battery pack (3), **characterized by**
- increasing the first threshold if the temperature surpasses a threshold.

13. A computer program with a program code configured to perform the method according to claim 12 when the computer program runs on a computer.

## Patentansprüche

1. Ladungsmonitor (21) zum Überwachen eines Ladevorgangs eines Akkupacks (3) durch ein Ladegerät (20), umfassend:
- einen Wiederaufladehäufigkeitsbestimmer (211), der dazu ausgelegt ist, eine Wiederaufladehäufigkeit des Akkupacks (3) zu bestimmen, und
- einen Akkupackstatusbestimmer (212), der dazu ausgelegt ist, einen Status des Akkupacks (3) basierend auf der Wiederaufladehäufigkeit zu bestimmen als:
- betriebsbereit, wenn die Wiederaufladehäufigkeit unter einem ersten Schwellenwert liegt, und
- beschädigt, wenn die Wiederaufladehäufigkeit über dem ersten Schwellenwert liegt;
wobei der Ladungsmonitor (21) einen Temperatursensor (213) umfasst, der dazu ausgelegt ist, eine Temperatur des Akkupacks (3) zu messen, **dadurch gekennzeichnet, dass**
der Akkupackstatusbestimmer (212) dazu ausgelegt ist, den ersten Schwellenwert zu erhöhen, wenn die Temperatur einen Schwellenwert überschreitet.

2. Ladungsmonitor (21) nach Anspruch 1,
wobei der Wiederaufladehäufigkeitsbestimmer (211) ausgelegt ist zum
- Bestimmen von Ladezeiten (t_{ch}) des Akkupacks (3) und/oder Bestimmen von Entladezeiten (t_{disch}) des Akkupacks (3) während eines vorgegebenen Zeitraums, und
- Bestimmen der Wiederaufladehäufigkeit des Akkupacks (3) aus den bestimmten Ladezeiten (t_{ch}) des Akkupacks (3) und/oder Entladezeiten (t_{disch}) des Akkupacks (3) innerhalb des voreingestellten Zeitraums.

3. Ladungsmonitor (21) nach Anspruch 2,
wobei der Wiederaufladehäufigkeitsbestimmer (211) ausgelegt ist zum
- Bestimmen einer Ladezeit (t_{ch}) als eine Zeit von einem Beginn eines Ladezyklus bis zu einem Ende des Ladezyklus, und/oder
- Bestimmen einer Entladezeit (t_{disch}) als eine Zeit von einem Ende eines Ladezyklus bis zu einem Beginn eines weiteren Ladezyklus.

4. Ladungsmonitor (21) nach einem der Ansprüche 1 bis 3,
wobei der Wiederaufladehäufigkeitsbestimmer (211) ausgelegt ist zum:
- Überwachen einer Spannung des Akkupacks (3), das mit dem Ladegerät (20) verbunden ist,
- Bestimmen eines Beginns eines Ladezyklus, wenn die Spannung unter einen ersten Spannungsschwellenwert fällt und anschließend über den ersten Spannungsschwellenwert ansteigt, und
- Bestimmen eines Endes eines Ladezyklus, wenn die Spannung einen zweiten Spannungsschwellenwert überschreitet.

5. Ladungsmonitor (21) nach einem der Ansprüche 1 bis 4,
wobei der Akkupackstatusbestimmer (212) dazu ausgelegt ist, innerhalb einer Inbetriebnahmezeit (t_{com}), die zu einem Beginn eines ersten Ladens des Akkupacks (3) durch das Ladegerät (20) beginnt, nach erstmaligem Erreichen einer Nennspannung des Akkupacks (3) endet, den ersten Schwellenwert zu erhöhen.

6. Ladungsmonitor (21) nach einem der Ansprüche 1 bis 5,
wobei der Akkupackstatusbestimmer (212) dazu ausgelegt ist, aus einem Akkustatistikspeicher (34) des Akkupacks (3) ein Alter und/oder eine Anzahl früherer Ladezyklen des Akkupacks (3) auszulesen und wobei, wenn das Alter des Akkupacks (3) über einem dritten Schwellenwert liegt und/oder eine Anzahl früherer Ladezyklen des Akkupacks (3) über einem vierten Schwellenwert liegt, der Akkupackstatusbestimmer (212) dazu ausgelegt ist, den ersten Schwellenwert zu erhöhen.

7. Ladevorrichtung (2), umfassend ein Ladegerät (20), das dazu ausgelegt ist, einen Akkupack (3) aufzuladen, und einen Ladungsmonitor (21) nach einem der Ansprüche 1 bis 6.

8. Ladevorrichtung (2) nach Anspruch 7,
wobei das Ladegerät (20) angepasst ist zum
- Überwachen einer Spannung des Akkupacks (3), das mit dem Ladegerät (20) verbunden ist,
- Bestimmen eines Beginns eines Ladezyklus, wenn die Spannung unter einen ersten Spannungsschwellenwert fällt und anschließend über den ersten Spannungsschwellenwert ansteigt, und
- Bestimmen eines Endes eines Ladezyklus, wenn die Spannung einen zweiten Ladezyklus überschreitet.

9. Akkusystem (1), umfassend eine Ladevorrichtung (2) nach Anspruch 10 und einen wiederaufladbaren Akkupack (3).

10. Notbeleuchtungstreiber, umfassend eine Ladevorrichtung (2) nach Anspruch 7 oder 8 und einen wiederaufladbaren Akkupack (3).

11. Notbeleuchtungsvorrichtung, umfassend einen Notbeleuchtungstreiber nach Anspruch 10 und eine Lichtquelle, die dazu bestimmt ist, im Falle einer Notbeleuchtungssituationen von dem Akkupack (3) gespeist zu werden.

12. Verfahren zum Überwachen eines Ladevorgangs eines Akkupacks (3), umfassend:
- Bestimmen (100) einer Wiederaufladehäufigkeit des Akkupacks (3) und
- Bestimmen (101) eines Status des Akkupacks (3) basierend auf der Wiederaufladehäufigkeit als:
- betriebsbereit, wenn die Wiederaufladehäufigkeit unter einem ersten Schwellenwert liegt, und
- beschädigt, wenn die Wiederaufladehäufigkeit über dem ersten Schwellenwert liegt, und
- Messen einer Temperatur des Akkupacks (3), **gekennzeichnet durch**
- Erhöhen des ersten Schwellenwerts, wenn die Temperatur einen Schwellenwert überschreitet.

13. Computerprogramm mit einem Programmcode, der dafür konfiguriert ist, um das Verfahren nach Anspruch 12 durchzuführen, wenn das Computerprogramm auf einem Computer läuft.

## Revendications

1. Moniteur de charge (21) pour surveiller un processus de charge d'un bloc-batterie (3) par un chargeur (20), comprenant :
- un dispositif de détermination de fréquence de recharge (211), conçu pour déterminer une fréquence de recharge du bloc-batterie (3), et
- un dispositif de détermination d'état de bloc-batterie (212), conçu pour déterminer un état de bloc-batterie (3) en fonction de la fréquence de recharge comme :
- opérationnel, si la fréquence de recharge est inférieure à un premier seuil, et
- endommagé, si la fréquence de recharge est supérieure au premier seuil ;
dans lequel le moniteur de charge (21) comprend un capteur de température (213), conçu pour mesurer une température du bloc-batterie (3),
**caractérisé en ce que**
le dispositif de détermination d'état de bloc-batterie (212) est conçu pour augmenter le premier seuil si la température dépasse un seuil.

2. Moniteur de charge (21) selon la revendication 1,
dans lequel le dispositif de détermination de fréquence de recharge (211) est conçu pour
- déterminer des temps de charge (t_{ch}) du bloc-batterie (3) et/ou déterminer des temps de décharge (t_{disch}) du bloc-batterie (3) pendant une période de temps prédéfinie, et
- déterminer la fréquence de recharge du bloc-batterie (3) à partir des temps de charge (t_{ch}) du bloc-batterie (3) et/ou des temps de décharge (t_{disch}) du bloc-batterie (3) déterminés dans la période de temps prédéfinie.

3. Moniteur de charge (21) selon la revendication 2,
dans lequel le dispositif de détermination de fréquence de recharge (211) est conçu pour
- déterminer un temps de charge (t_{ch}) en guise de temps à partir d'un début d'un cycle de charge jusqu'à une fin du cycle de charge, et/ou
- déterminer un temps de décharge (t_{disch}) en guise de temps à partir d'une fin d'un cycle de charge jusqu'à un début d'un autre cycle de charge.

4. Moniteur de charge (21) selon l'une quelconque des revendications 1 à 3,
dans lequel le dispositif de détermination de fréquence de recharge (211) est conçu pour :
- surveiller une tension du bloc-batterie (3) connecté au chargeur (20),
- déterminer un début d'un cycle de charge, si la tension descend en dessous d'un premier seuil de tension et augmente ensuite au-dessus du premier seuil de tension, et
- déterminer une fin d'un cycle de charge, si la tension dépasse un deuxième seuil de tension.

5. Moniteur de charge (21) selon l'une quelconque des revendications 1 à 4,
dans lequel le dispositif de détermination d'état de bloc-batterie (212) est conçu pour, dans un temps de mise en service (t_{com}) débutant à un début d'une première charge du bloc-batterie (3) par le chargeur (20), finissant après qu'une tension nominale du bloc-batterie (3) a été atteinte pendant un premier temps, augmenter le premier seuil.

6. Moniteur de charge (21) selon l'une quelconque des revendications 1 à 5,
dans lequel le dispositif de détermination d'état de bloc-batterie (212) est conçu pour lire d'un stockage de statistiques de batterie (34) du bloc-batterie (3), un âge et/ou un nombre de cycles de charge précédents du bloc-batterie (3), et dans lequel, si l'âge du bloc-batterie (3) est supérieur à un troisième seuil, et/ou un nombre de cycles de charge précédents du bloc-batterie (3) est supérieur à un quatrième seuil, le dispositif de détermination d'état de bloc-batterie (212) est conçu pour augmenter le premier seuil.

7. Dispositif de charge (2), comprenant un chargeur (20), conçu pour charger un bloc-batterie (3), et un moniteur de charge (21) selon l'une quelconque des revendications 1 à 6.

8. Dispositif de charge (2) selon la revendication 7,
dans lequel le chargeur (20) est conçu pour
- surveiller une tension du bloc-batterie (3) connecté au chargeur (20),
- déterminer un début d'un cycle de charge, si la tension descend en dessous d'un premier seuil de tension et augmente ensuite au-dessus du premier seuil de tension, et
- déterminer une fin d'un cycle de charge, si la tension dépasse un second cycle de charge.

9. Système de batterie (1), comprenant un dispositif de charge (2) selon la revendication 10 et un bloc-batterie rechargeable (3).

10. Circuit d'attaque d'éclairage de secours, comprenant un dispositif de charge (2) selon la revendication 7 ou 8 et un bloc-batterie rechargeable (3).

11. Dispositif d'éclairage de secours, comprenant un circuit d'attaque d'éclairage de secours selon la revendication 10 et une source de lumière qui est conçue pour être alimentée par le bloc-batterie (3) en cas de situations d'éclairage de secours.

12. Procédé de surveillance d'un processus de charge d'un bloc-batterie (3), comprenant :
- la détermination (100) d'une fréquence de recharge du bloc-batterie (3), et
- la détermination (101) d'un état de bloc-batterie (3) en fonction de la fréquence de recharge comme :
- opérationnel, si la fréquence de recharge est inférieure à un premier seuil, et
- endommagé, si la fréquence de recharge est supérieure au premier seuil, et
- la mesure d'une température du bloc-batterie (3),
**caractérisé par**
- l'augmentation du premier seuil si la température dépasse un seuil.

13. Programme informatique avec un code de programme configuré pour exécuter le procédé selon la revendication 12 lorsque le programme informatique est exécuté sur un ordinateur.
